# EUROPEAN PATENT APPLICATION

(11) **EP 2 028 378 A2**
(43) Date of publication of application: **25.02.2009**
(21) Application number: 08014930.5
(22) Date of filing: 22.08.2008
(51) Int. Cl.: F15B 15/24, H01L 21/687

(54) **Mechanism for varying the end of stroke position of a cylinder and substrate processing apparatus including same**

(30) Priority: 23.08.2007 JP 2007217119
(71) Applicant: Tokyo Electron Limited, Tokyo 107-6325 (JP)
(72) Inventor: Hayashi, Daisuke, Tokyo 107-6325 (JP); Nonaka, Ryo, Tokyo 107-6325 (JP)
(74) Representative: HOFFMANN EITLE

(57) **Abstract**

A cylinder stop position varying mechanism (122) is employed in a cylinder (106) having a piston (107) and a shaft (108). The cylinder stop position varying mechanism includes a stopper (109) fitted onto the shaft; a pair of limiters (110a,110b) for stopping a reciprocating movement of the piston by contact with the stopper; and a limiter moving mechanism (111,112) for varying positions of the limiters. The cylinder is driven by a hydraulic pressure, and the limiter moving mechanism (111,112) is provided to each of the pair of limiters (110a,110b) to control positions of the limiters independently.

## Description

The present invention relates to a cylinder stop position varying mechanism and a substrate processing apparatus including same; and, more particularly, to a cylinder stop position varying mechanism capable of moving up/down and forward/backward an object with almost no vibration and freely changing a stop position of the object depending on processes and a substrate processing apparatus using same.

In a semiconductor manufacturing process, a mounting table having thereon a target object, e.g., a semiconductor substrate (wafer) or the like, or the wafer itself is raised and lowered depending on processes in order to perform various treatments on the wafer.

For example, Patent Document 1 describes a heat treatment device having an elevation mechanism for raising and lowering a wafer mounted on a mounting table with respect to a heat source provided thereabove.

In the heat treatment device described in Patent Document 1, the wafer is raised and lowered to be heat-treated by an up-down cylinder. More specifically, the wafer is raised by extension of the up-down cylinder, and approaches a top cover serving as a cooling unit of which temperature is controlled to be set to a desired level by cooling water supplied from a cooling water supply source. Under this condition, the wafer is rapidly cooled to a desired temperature. After the wafer is cooled to the desired temperature, the up-down cylinder is contracted in response to a control signal that triggers the start of a downward operation. The contraction of the up-down cylinder lowers an elevation plate and supporting pins. As a consequence, the wafer is mounted on the mounting table.

Here, the wafer is raised to make it approach close to the heat source (i.e., the top cover) so that the wafer is cooled to a desired temperature. The cooled wafer is lowered and mounted on the mounting table. In the vertically moving process, the wafer may stop at two predetermined vertical positions. Thus, the up-down cylinder whose stroke determines the stop positions can be used as a driving unit.

Patent Document 2 discloses an elevation driving unit using a ball screw and a stepping motor. An elevation driving mechanism illustrated in Figs. 3 and 13 of Patent Document 2 includes a vertical ball screw, a stepping motor for rotating the ball screw, a guide rail disposed in parallel with the ball screw, a screw coupling member fixed to a supporting rod and screwed to the ball screw, and a guide member guided by the guide rail and fixed to the screw coupling member. A wafer supporting member is configured to be raised and lowered via the supporting rod by rotating the ball screw by driving the stepping motor. With such a configuration, the stop position of the wafer can be easily controlled to be set at multi-levels.

In a semiconductor processing apparatus, a plurality of treatments are often performed in a same chamber. In that case, the distance between the wafer and the stage or the heat source needs to be controlled to be adjusted at multi-levels.

When the vertical position of the wafer elevation mechanism needs to be controlled to be set at multi-levels by the elevation mechanism, the stop position is controlled through a software by using a stepping motor, a servo motor or the like as the driving unit of the elevation mechanism.

Meanwhile, when the cylinder is used as the driving unit of the elevation mechanism, the stop position cannot be controlled to be set at multi-levels, unlike the case of using the stepping motor, the servo motor or the like. This is because the stop positions are determined to be restricted to two vertical positions by the stroke of the cylinder.

Patent Document 3 discloses a multi-stroke cylinder which has a two-stage stop positions for an object and provides an increased freedom of a stroke to accommodate various types of welded members. The multi-stroke cylinder described in Patent Document 3 varies the stop position by making a stopper provided at the leading end of an auxiliary rod extending from a main piston to the outside of a head cover contact with a stop position determining member and by contacting a position setting rod with a back of the stop position setting piston.

However, in the elevation mechanism of the semiconductor processing apparatus, the stop position needs to be controlled to be set at multi-levels, as described above. Further, the stop position needs to be precisely controlled. Accordingly, it is not possible to use the multi-stroke cylinder of Patent Document 3 as the elevation mechanism of the semiconductor processing apparatus.
[Patent Document 1] Japanese Patent Laid-open Publication No. H7-201719
[Patent Document 2] Japanese Patent Laid-open Publication No. 2001-144038
[Patent Document 3] Japanese Patent Laid-open Publication No. 2002-250308

As set forth above, in the semiconductor processing, e.g., an etching or an ashing on the wafer, the temperature of the wafer needs to be precisely controlled. Therefore, the wafer and the mounting table is raised and lowered to be at an extremely precise position with respect to the heat source.

Further, in the wafer processing apparatus, it is very important to raise and lower the wafer and the mounting table without generating vibration. If vibration is generated during the vertical moving operation, friction is developed between the wafer and the mounting table and, thus, minute peeling materials may be produced by a frictional force applied to the friction surfaces thereof. The minute peeling materials thus produced are scattered as dusts or particles, so that the atmosphere in the chamber or the cleanness of the wafer can be greatly deteriorated.

As the elevation mechanism of the wafer and the mounting table, there is employed a motor driving type for driving a screw axis or a pulley by a motor, or a hydraulic cylinder type for driving a piston in the cylinder by a hydraulic pressure.

However, the motor driving type does not ensure a complete suppression of the vibration. Meanwhile, the hydraulic cylinder type has a simpler structure than that of the motor driving type, so that the vibration is rarely generated. Therefore, it is preferable to employ the cylinder type for the cleanness of the wafer. However, in the cylinder type, the stop position cannot be freely controlled.

In view of the above, the present invention provides a cylinder stop position varying mechanism capable of raising and lowering a substrate and a mounting table without vibration and freely changing an upper and a lower stop position during elevation in a processing apparatus for processing a target object, e.g., a semiconductor substrate (wafer) or the like, and a substrate processing apparatus having same.

In accordance with an aspect of the invention, there is provided a cylinder stop position varying mechanism employed in a cylinder having a piston and a shaft. The cylinder stop position varying mechanism includes a stopper fitted onto the shaft; a pair of limiters for stopping a reciprocating movement of the piston by contact with the stopper; and a limiter moving mechanism for varying positions of the limiters.

It is preferable that the cylinder is driven by a hydraulic pressure.

In the cylinder stop position varying mechanism, a limiter moving mechanism is provided to each of the pair of limiters to control positions of the limiters independently.

In the cylinder stop position varying mechanism, it is preferable that the limiter moving mechanism is controlled by a motor.

By employing the above configuration, each of the limiters for determining an upper end and a lower end stop position can move independently. Therefore, the positions of the limiters can be simply set and, thus, time required therefor can be reduced. Further, when the limiters move independently, the generation of vibration can be further suppressed.

In the cylinder stop position varying mechanism, it is preferable that the limiter moving mechanism has a sensor for detecting positions of the limiters and/or a sensor for detecting a position of the stopper.

In the cylinder stop position varying mechanism, it is preferable that each of the limiters has at a contact portion with the stopper a shock buffer for absorbing shock generated by the contact with the stopper.

In accordance with another aspect of the invention, there is provided a substrate processing apparatus which includes a processing chamber for accommodating therein a substrate to be processed; a mounting table provided in the processing chamber, for mounting thereon the substrate; a shutter for opening and closing a loading/unloading port through which the substrate is loaded into and unloaded from the processing chamber; a processing gas injection mechanism provided to face the substrate on the mounting table, for injecting processing gas into the processing chamber; a gas exhaust mechanism for exhausting the processing chamber; and lift pins optionally provided in the mounting table, for supporting a bottom surface of the substrate.

In the substrate processing apparatus, at least one of the mounting table, the lift pins and the shutter is raised and lowered by a cylinder having a piston and a shaft, the cylinder employing a cylinder stop position varying mechanism.

The cylinder stop position varying mechanism includes a stopper fitted onto the shaft; a pair of limiters for stopping a reciprocating movement of the piston by contact with the stopper; and a limiter moving mechanism for varying positions of the limiters.

In accordance with the aspects of the present invention, it is possible to raise and lower a substrate or a mounting table without vibration, and also possible to freely change an upper and a lower stop position during elevation in a processing apparatus for processing a target object, e.g., a semiconductor substrate (wafer) or the like. Further, the present invention can greatly suppress vibration generated during elevation, compared to a conventional elevation mechanism using a motor. As a consequence, it is possible to greatly suppress dusts, particles or the likes caused by the vibration.

Besides, the present invention suppresses vibration by a low-priced mechanism, which is practically effective.

The objects and features of the present invention will become apparent from the following description of embodiments, given in conjunction with the accompanying drawings, in which:
Fig. 1 shows an example of a schematic overall configuration of a substrate processing apparatus (etching apparatus);
Fig. 2 describes a schematic cross sectional view of a cylinder stop position varying mechanism in accordance with a first embodiment of the present invention;
Fig. 3 provides a schematic cross sectional view of a substrate processing apparatus in accordance with the first embodiment of the present invention;
Fig. 4 presents a schematic cross sectional view of a substrate processing apparatus in accordance with a second embodiment of the present invention; and
Fig. 5 offers schematic cross sectional view of a substrate processing apparatus in accordance with a third embodiment of the present invention.

The embodiments of the present invention will be described with reference to the accompanying drawings which form a part hereof.

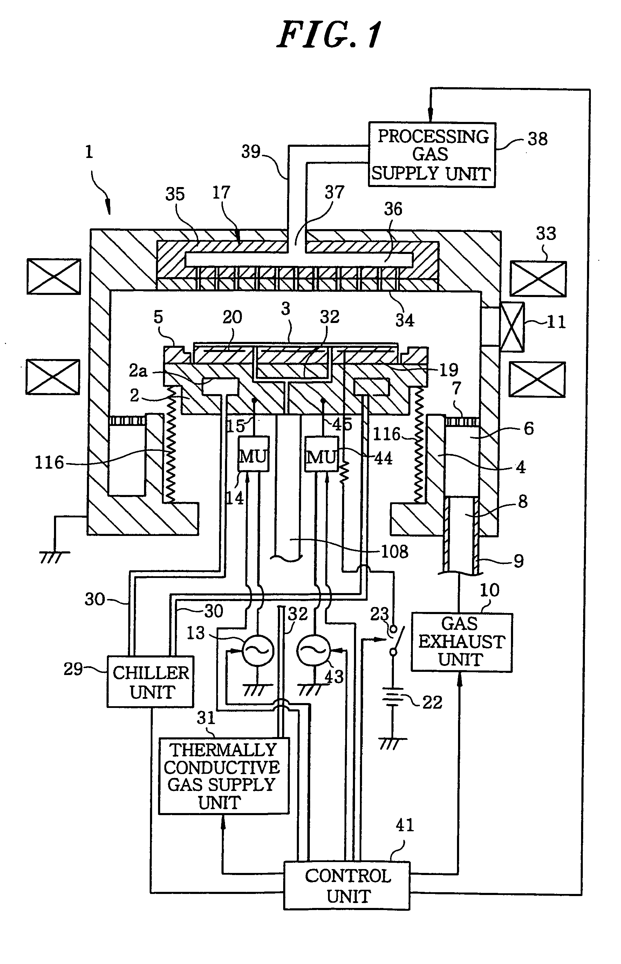

Fig. 1 shows an example of a schematic overall configuration of a substrate processing apparatus (etching apparatus). In Fig. 1, a reference numeral 1 indicates a cylindrical chamber which is airtightly sealed. The chamber 1 is made of, e.g., aluminum, stainless steel or the like, and is grounded to the earth.

The chamber 1 has therein a circular plate-shaped mounting table (susceptor) 2 for mounting thereon a substrate to be processed, e.g., a semiconductor wafer (hereinafter, referred to as a "substrate 3"). The susceptor 2 is made of a conductive material, e.g., aluminum or the like, and serves as a lower electrode. The susceptor 2 is supported by a driving shaft 108 of a cylinder stop position varying mechanism of the present invention which will be described later.

The susceptor 2 is connected to a vacuum bellows 116, so that the chamber 1 is airtightly maintained. Provided on a top surface of the susceptor 2 is an annular focus ring 5 surrounding the susceptor 2, the focus ring 5 being made of quartz or the like.

An annular gas exhaust path 6 is formed between a sidewall of the chamber 1 and a supporting portion 4. An annular baffle plate 7 is provided at the entrance of the gas exhaust path 6 or in the middle thereof. A gas exhaust port 8 is provided at a bottom portion of the gas exhaust path 6. A gas exhaust unit 10 is connected to the gas exhaust port 8 via a gas exhaust line 9. The gas exhaust unit 10 has a vacuum pump, and depressurizes a processing space inside the chamber 1 to a predetermined vacuum level. Attached to the sidewall of the chamber 1 is a shutter 11 for opening or closing a loading/unloading port of the substrate 3.

A high frequency power supply 13 for plasma generation is electrically connected to the susceptor 2 via a matching unit 14 and a power feed rod 15. The high frequency power supply 13 applies a high frequency power having a high frequency (HF) of, e.g., 40 MHz, to the susceptor 2 serving as the lower electrode. A shower head 17 serving as an upper electrode is provided at a ceiling portion of the chamber 1. By applying the high frequency power from the high frequency power supply 13 to the susceptor 2, a plasma is generated between the susceptor 2 and the shower head 17.

Further, a high frequency power supply 43 for bias generation which induces ions in the plasma to the substrate 3 is connected to the susceptor 2 via a matching unit 44 and a power feed rod 45. The high frequency power supply 43 applies a high frequency power having a low frequency (LF) of, e.g., 12.88 MHz, 3.2 MHz or the like, to the susceptor 2. The ions in the plasma are induced onto the substrate 3 by the applied high frequency power.

An electrostatic chuck 19 is disposed on a top surface of the mounting table 12 to hold the substrate 3 by an electrostatic adsorptive force. The electrostatic chuck 19 is made of a dielectric material such as ceramic or the like. The electrostatic chuck 19 has therein a HV (high voltage) electrode 20 (internal electrode) which is a conductor. The HV electrode 20 is made of a conductive film, e.g., copper, tungsten or the like.

A DC power supply 22 is electrically connected to the HV electrode 20 via a switch 23. The DC power supply 22 applies a DC voltage of plus or minus 2500 V, 3000 V or the like to the HV electrode 20. The switch 23 switches polarity of the DC voltage applied from the DC power supply 22 to the electrostatic chuck 19 between a positive voltage and a negative voltage. When a DC voltage is applied from the DC power supply 22 to the HV electrode 20, the substrate 3 is adsorptively held on the electrostatic chuck 19 by a Coulomb force. The electrostatic chuck 19 is classified into a single electrode and a dual electrode type, and each of them is divided into Coulombic and Johnson-Rahbek types.

Provided in the susceptor 2 is a coolant chamber 2a that is circumferentially extended. A coolant, e.g., cooling water, kept at a predetermined temperature is supplied from a chiller unit 29 into the coolant chamber 2a via a line 30 to be circulated therein. Accordingly, a processing temperature of the substrate 3 on the electrostatic chuck 19 can be controlled by the temperature of the coolant.

A thermally conductive gas, e.g., He gas, is supplied from a thermally conductive gas supply unit 31 into a space between the top surface of the electrostatic chuck 19 and the backside surface of the substrate 3 via a gas supply line 32. The backside surface of the substrate 3 and the top surface of the electrostatic chuck 19 are not flat but uneven in a microscale. Accordingly, a contact area between the substrate 3 and the electrostatic chuck 19 is small. By supplying a thermally conductive gas to the space between the backside surface of the substrate 3 and the electrostatic chuck 19, the thermal conductivity between the substrate 3 and the electrostatic chuck 3 can be improved.

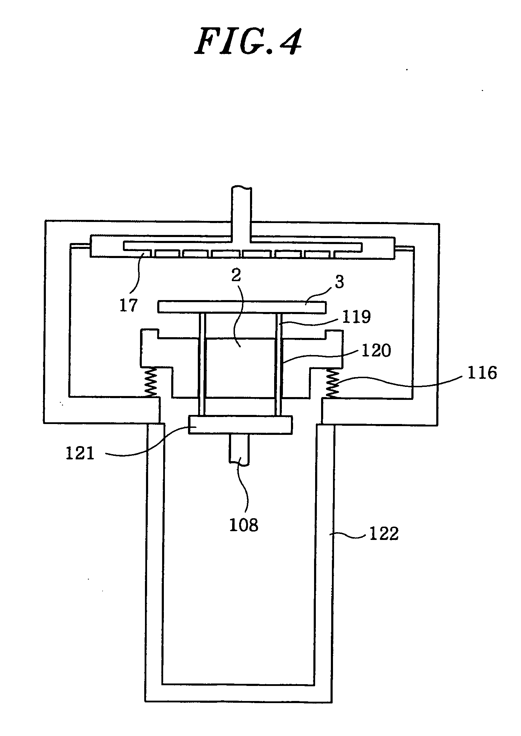

Provided in the susceptor 2 is supporting pins 119 (see Fig. 4) which are protruded above the top surface of the electrostatic chuck 19 or retreated below the top surface of the electrostatic chuck 19. In order to attract the substrate 3 toward the electrostatic chuck 19, the substrate 3 is mounted on the supporting pins 119 that have been protruded above the top surface of the electrostatic chuck 19, and then is mounted on the top surface of the electrostatic chuck 19 by lowering the supporting pins 119. Meanwhile, in order to separate the substrate 3 from the electrostatic chuck 19, the supporting pins 119 that have been retreated below the top surface of the electrostatic chuck 19 are raised and, thus, the substrate 3 that has been attracted on the top surface of the electrostatic chuck 19 is lifted by the supporting pins 119.

The shower head 17 provided at the ceiling portion includes a bottom electrode plate 34 having in a bottom surface thereof a plurality of gas through-holes and an electrode support 35 for detachably supporting the electrode plate 34. The electrode support 35 has therein a buffer chamber 36, and a gas inlet opening 37 provided at a top portion of the buffer chamber 36 is connected to a processing gas supply unit 38 via a gas supply line 39.

The shower head 17 faces the susceptor 2 in parallel, and is grounded to the earth. The shower head 17 and the susceptor 2 serve as a pair of electrodes, i.e., an upper electrode and a lower electrode. A high frequency electric field is vertically formed between the shower head 17 and the susceptor 2 by the high frequency power. A high-density plasma is generated near the surface of the susceptor 2 by a high frequency discharge.

An annular ring magnet 33 is coaxially disposed around the chamber 1. A magnetic field is formed in the processing space between the susceptor 2 and the shower head 17 by the ring magnet 33. The ring magnet 33 can rotate around the chamber 1 by a rotation unit (not shown).

A control unit 41 controls the operation of respective parts of the plasma etching apparatus, such as the gas exhaust unit 10, the high frequency power supply units 13 and 43, the electrostatic chuck switch 23, the chiller unit 29, the thermally conductive gas supply unit 31, the processing gas supply unit 38 and the like.

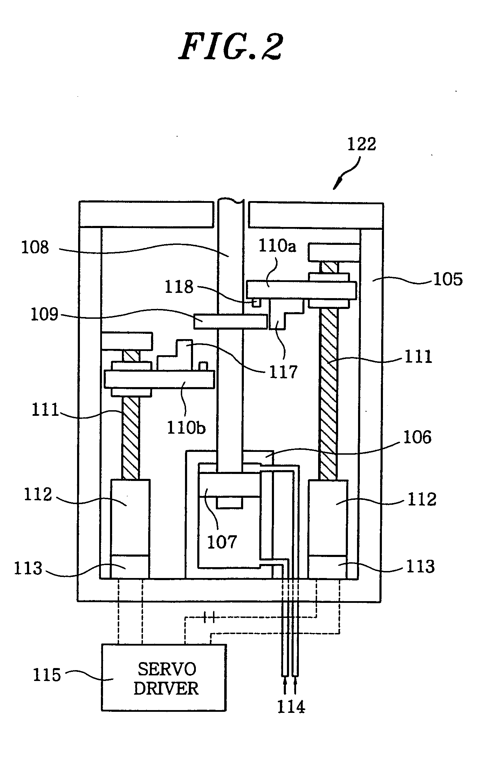

Fig. 2 describes a schematic cross sectional view of a cylinder stop position varying mechanism 122 in accordance with a first embodiment of the present invention. The cylinder stop position varying mechanism 122 is accommodated in a box 105. An air cylinder 106 stands upright on a central bottom portion of the box 105, a driving shaft 108 for driving an object to be elevated is connected to a piston 107 provided in the air cylinder 106.

The piston 107 is raised or lowered by supplying piston driving air 114 from an air source (not shown) to a lower or an upper portion of the piston 107 in the air cylinder 106. Accordingly, the driving shaft 108 moves in a vertical direction. The vertical movement of the driving shaft 108 is restricted by an upper end limiter 110a and a lower end limiter 110b. That is, the driving shaft 108 stops at a position at which the stopper 109 attached to the driving shaft 108 makes a contact with the upper end limiter 110a or the lower end limiter 110b. The present invention is characterized in that the stop positions of the upper end and the lower end limiter 110a and 110b can be arbitrarily set.

In the present embodiment, the upper end limiter 110a and the lower end limiter 110b are vertically driven by ball screws 111. Each ball screw 111 is driven to rotate by a servo motor 112. The servo motor 112 is driven under the control of a servo driver 115, and an encoder 113 disposed below each servo motor 112 outputs information on the number of revolutions or a rotation angle of each servo motor 112. Based on such information, a rotation amount of each servo motor 112, i.e., each of moving amounts of the upper end and the lower end limiter 110a and 110b, can be precisely controlled.

Further, a position sensor 117 is attached to each of the upper end and the lower end limiter 110a and 110b, and detects a position of the stopper 109 without making contact therewith. With the use of the position sensors 117, it is possible to determine that the stopper 109 has moved up to the position of the upper end limiter 110a or the lower end limiter 110b. As the position sensor 117, a proximity sensor, a photo micro sensor or the like can be used.

The following is a brief description of the operation of the cylinder stop position varying mechanism 122. When the stop position of the air cylinder 106 (the stop position of the driving shaft 108) needs to be changed, e.g., when the position of the driving shaft 108 needs to be changed upwards, first of all, the upper end limiter 110a is moved to a required position. Next, the driving shaft 108 is raised by applying an air pressure to the air cylinder 106 to move the piston 107 up. Further, whether the stopper 109 has reached a required position or not is checked by the position sensor 117.

Disposed on each of a bottom surface of the upper end limiter 110a and a top surface of the lower end limiter 110b is an air cushion 118 for absorbing shock generated by collisions between respective limiters and the stopper 109.
As for an air cushion, it is possible to select one among various products available in the market.

In the present embodiment, the air cylinder 106 is employed. However, a hydraulic cylinder can be used instead. In the case of a cylinder driven by a gas, shock generated by the collision between the stopper and the limiter is absorbed by compression of the gas in the cylinder and thus is greatly suppressed. Therefore, it is preferable to use a cylinder driven by a gas.

In the present embodiment, motors are used for driving the limiters. Since, however, the limiters driven by the motors are extremely light, vibrations generated therefrom are considerably small. Further, the mounting table is not driven directly by the motors, so that the motors rarely contribute to the productions of particles, dusts or the likes in the chamber.

In the present embodiment, the upper end and the lower end limiters 110a and 110b are raised and lowered by separate driving units, respectively. However, the upper end and the lower end limiters 110a and 110b can be driven by switching a single driving unit. When the upper end and the lower end limiters 110a and 110b are independently driven, the setting operation for the limiters 110a and 110b becomes simpler, shortening time required therefor.

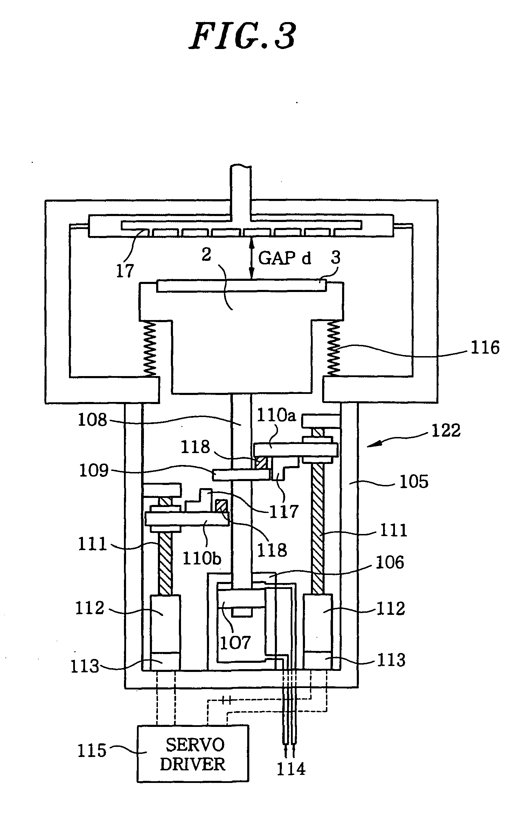

Fig. 3 provides a schematic cross sectional view of a substrate processing apparatus in accordance with the first embodiment of the present invention. The mounting table 2 is provided almost at the center of the chamber 1, and the substrate 3 is mounted thereon. The mounting table 2 has an electrostatic chuck, and an electrode plate is buried under a mounting surface made of a dielectric material. By applying a high DC voltage thereto, the substrate 3 is electrostatically attracted to be held by a Coulomb force or a Johnson-Rahbek force.

Moreover, the mounting table 2 is cooled by a coolant flowing therein. The shower head 17 is provided above the substrate 3. A high frequency voltage is applied to the shower head 17 while a gas is introduced therein, so that the gas is converted into a plasma. The generated plasma is supplied to the substrate in a form of a shower through a plurality of holes formed in a bottom surface. Further, the chamber 1 is vacuum-evacuated by a vacuum pump (not shown).

Provided below the chamber 1 is an elevation mechanism for raising and lowering the mounting table 2. As the elevation mechanism, there is used the cylinder stop position varying mechanism 122 in accordance with the embodiment of the present invention which is shown in Fig. 2. Since the configuration of the cylinder stop position varying mechanism 122 has been described above, the redundant description thereof will be omitted. The mounting table 2 and the box 105 are connected by the vacuum bellows 116. Accordingly, the mounting table 2 can be raised and lowered while the chamber 1 is airtightly maintained.

In the substrate processing apparatus of the present embodiment, the substrate 3 mounted on the mounting table 2 can be rapidly moved between two vertical levels, so that the set heights of the substrate 3 can be arbitrarily and independently changed in a vertical direction. That is, a distance (gap) d between the bottom surface of the shower head 17 and the top surface of the substrate 3 can be arbitrarily varied.

The gap d is a factor of determining the characteristics of the plasma processing, and especially temperature of the substrate 3. Since the relationship between the substrate temperature and the gap d can be obtained by measurement or experience, the substrate temperature can be controlled to be set at a required level by appropriately setting the gap d. By using the cylinder stop position varying mechanism 122 in accordance with the embodiment of the present invention, the distance between the shower head 17 and the substrate 3 can be varied depending on each processing and, thus, the stability of the processing can be improved. Especially, when the temperature of the substrate needs to be changed in two steps in a series of processes, the temperature can be controlled by varying the height of the substrate 3 by using the upper end limiter 110a for setting the high temperature and the lower end limiter 110b for setting the low temperature.

Fig. 4 presents a schematic cross sectional view of a substrate processing apparatus in accordance with a second embodiment of the present invention. In this apparatus, the mounting table 2 has a plurality of through-holes 120 through which the supporting pins 119 are inserted to pass. The supporting pins 119 are fixed to a pin attaching member 121. Further, the pin attaching member 121 is attached to a top end of the driving shaft 108, and is vertically moved by the movement of the piston 107, as shown in Fig. 2. The substrate 3 is raised and lowered by the vertical movement of the supporting pins 119 while being mounted on the top ends of the supporting pins 119.

In this substrate processing apparatus, the cylinder stop position varying mechanism 122 is also provided below the chamber 1. The cylinder stop position varying mechanism 122 is similarly configured to the one illustrated in Fig. 2 in that the vertical movement is restricted by the stopper 109 and the upper end and the lower end limiter 110a and 110b. Further, the upper end and the lower end limiter 110a and 110b are driven in the manner described above.

In this substrate processing apparatus, the substrate 3 can also be rapidly moved between two vertical levels. Therefore, the substrate processing apparatus in accordance with the present embodiment functions similarly to the one shown in Fig. 3 in that the set height of the substrate 3 can be changed arbitrarily and independently in a vertical direction. Accordingly, the temperature of the substrate 3 can be controlled to be set at two required levels. In a pin up state of the substrate processing process, the substrate 3 does not contact with the mounting table 2, so that the cooling effect on the substrate 3 by the mounting table 2 is insufficient. As a result, it is not possible to prevent the temperature of the substrate 3 from increasing.

When the substrate 3 is raised and lowered by the supporting pins 119, an abnormal discharge may be generated between the backside of the substrate 3 and the leading ends of the supporting pins 119. The abnormal discharge can be generated because a potential difference is developed between the substrate 3 and the supporting pins 119 when the substrate 3 does not contact with the supporting pins 119 (in a state where the substrate 3 is supported on the mounting table 2). In order to avoid the abnormal discharge, it is required to prevent a discharge from being generated between the substrate 3 and the supporting pins 119 by appropriately adjusting the position of the lower end limiter 110b. Therefore, it is effective to apply the cylinder stop position varying mechanism 122 in accordance with the embodiment of the present invention.

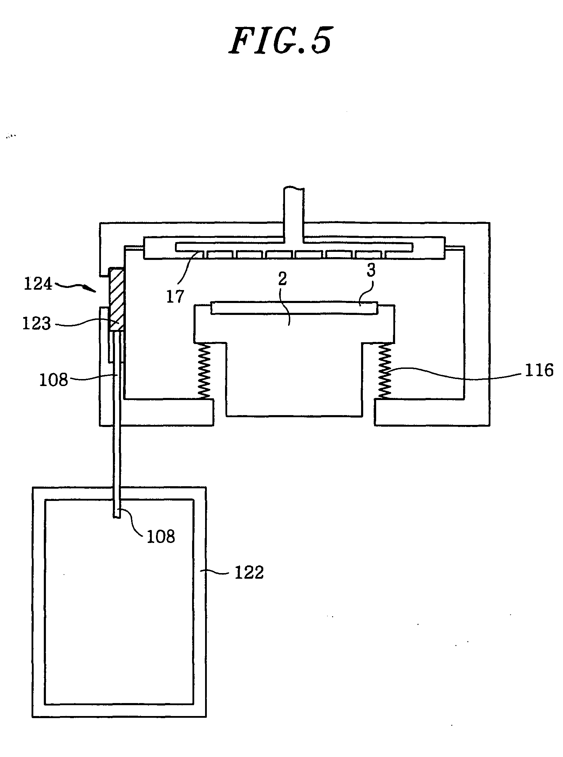

The cylinder stop position varying mechanism 122 of the present invention can be efficiently used as an elevation mechanism not only for vertically moving the substrate 3 or the mounting table 2 but also for vertically moving a shutter 123 for opening and closing a loading/unloading port 124 which is provided on the sidewall of the chamber 1 for loading and unloading the substrate 3. The vertical movement of the shutter 123 needs to be precisely controlled. Fig. 5 offers schematic cross sectional view of a substrate processing apparatus in accordance with a third embodiment of the present invention.

In this substrate processing apparatus, the shutter 123 for opening and closing the substrate loading/unloading port 124 provided on the sidewall of the chamber 1 is raised and lowered by the cylinder stop position varying mechanism 122 in accordance with the third embodiment of the present invention. The cylinder stop position varying mechanism 122 of the present embodiment is used to prevent an abnormal discharge from being generated due to a potential difference between the sidewall of the chamber 1 and the shutter 123 when a gap exists between the shutter 123 and the loading/unloading port 124. Accordingly, it is preferable to precisely adjust the upper end stop position of the shutter 123 by the cylinder stop position varying mechanism 122 of the present embodiment.

While the invention has been shown and described with respect to the embodiments, it will be understood by those skilled in the art that various changes and modification may be made without departing from the scope of the invention as defined in the following claims.

## Claims

1. A cylinder stop position varying mechanism for a cylinder having a piston and a shaft, comprising:
a stopper fitted onto the shaft;
a pair of limiters for stopping a reciprocating movement of the piston by contact with the stopper; and
a limiter moving mechanism for varying positions of the limiters.

2. The cylinder stop position varying mechanism of claim 1, wherein the cylinder is driven by a hydraulic pressure.

3. The cylinder stop position varying mechanism of claim 1 or 2, wherein the limiter moving mechanism is provided to each of the pair of limiters to control positions of the limiters independently.

4. The cylinder stop position varying mechanism of any one of claims 1 to 3, wherein the limiter moving mechanism is controlled by a motor.

5. The cylinder stop position varying mechanism of any one of claims 1 to 4, wherein the limiter moving mechanism has a sensor for detecting positions of the limiters.

6. The cylinder stop position varying mechanism of any one of claims 1 to 5, wherein each of the limiters has, at a contact portion with the stopper, a shock buffer for absorbing shock generated when it makes a contact with the stopper.

7. The cylinder stop position varying mechanism of any one of claims 1 to 6, wherein the limiter moving mechanism has a sensor for detecting a position of the stopper.

8. A substrate processing apparatus comprising:
a processing chamber for accommodating therein a substrate to be processed;
a mounting table provided in the processing chamber, for mounting thereon the substrate;
a shutter for opening and closing a loading/unloading port through which the substrate is loaded into and unloaded from the processing chamber;
a processing gas injection mechanism provided to face the substrate on the mounting table, for injecting processing gas into the processing chamber;
a gas exhaust mechanism for exhausting the processing chamber; and
lift pins provided in the mounting table, for supporting a bottom surface of the substrate,
wherein any one of the mounting table, the lift pins and the shutter is raised and lowered by a cylinder having a piston and a shaft, the cylinder employing a cylinder stop position varying mechanism including:
a stopper fitted onto the shaft;
a pair of limiters for stopping a reciprocating movement of the piston by contact with the stopper; and
a limiter moving mechanism for varying positions of the limiters.

9. The substrate processing apparatus of claim 8, wherein the cylinder is driven by a hydraulic pressure.

10. The substrate processing apparatus of claim 8 or 9,
wherein the limiter moving mechanism is provided to each of the pair of limiters to control positions of the limiters independently.

11. The substrate processing apparatus of any one of claims 8 to 10, wherein the limiter moving mechanism is controlled by a motor.

12. The substrate processing apparatus of any one of claims 8 to 11, wherein the limiter moving mechanism has a sensor for detecting positions of the limiters.

13. The substrate processing apparatus of any one of claims 8 to 12, wherein each of the limiters has, at a contact portion with the stopper, a shock buffer for absorbing shock generated when it makes a contact with the stopper.

14. The substrate processing apparatus of any one of claims 8 to 13, wherein the limiter moving mechanism has a sensor for detecting a position of the stopper.
